Europäisches Patentamt

European Patent Office

Office européen des brevets

(11) Publication number: **0 185 081**
**B1**

(12) **EUROPEAN PATENT SPECIFICATION**

(45) Date of publication of patent specification: **25.05.88**

(21) Application number: **85903413.4**

(22) Date of filing: **24.05.85**

(86) International application number:
**PCT/SE85/00219**

(87) International publication number:
**WO 86/00491 16.01.86 Gazette 86/02**

(51) Int. Cl.⁴: **H 05 K 9/00**

(54) **SEALING DEVICE IN METAL CABINETS, WHICH ARE USED TO SCREEN OFF ELECTROMAGNETIC FIELDS.**

(30) Priority: **18.06.84 SE 8403250**

(43) Date of publication of application:
**25.06.86 Bulletin 86/26**

(45) Publication of the grant of the patent:
**25.05.88 Bulletin 88/21**

(84) Designated Contracting States:
**AT BE CH DE FR GB LI NL**

(56) References cited:
**EP-A-0 030 529**
**EP-A-0 095 743**
**US-A-3 247 312**
**US-A-3 277 230**
**US-A-4 399 317**

(73) Proprietor: **TELEFONAKTIEBOLAGET L M ERICSSON**
**S-126 25 Stockholm (SE)**

(72) Inventor: **EKDAHL, Per, Anders, Allan**
**Plommonvägen 54**
**S-175 49 Järfälla (SE)**

Courier Press, Leamington Spa, England.

## Description

### TECHNICAL FIELD

The invention relates to a sealing device for compressing metallic gaskets along edges of doors of metal cabinets, which are used to screen off electromagnetic fields, the device including an elongate element, the length of which agrees with the length of an adjacent door edge, and which is pivotable about an axis, the elongate element being provided with a first elongate contact surface which, when the elongate element is pivoted to the closed position, presses against the gasket.

### BACKGROUND ART

Electromagnetic fields occur in nature as well as those caused by electric and electronic equipment. The fields can disturb the function of other electronic equipment, and the increased use of such equipment has resulted in increasing interference or disturbance problems. Electromagnetic fields can be prevented from coming into, or departing from, electronic equipment by building such equipment into closed metallic casings.

A problem in the construction of a cabinet for electronic equipment, a so-called apparatus cabinet, is to provide an effective seal at the door of the cabinet.

A previously proposed method of achieving such a seal is to implement the door and frame so that these can abut each other with metallic contact round the entire frame. This method puts great demands on tolerances in manufacture, however.

Another known method is to use a metallic sealing strip along the edges of the door. Problems occur here, however, caused by large stresses on the door suspension means and by the door having a tendency to warp.

From the document EP—A—0030 529 there is known a sealing device for compressing metallic gaskets along the edges of doors of metal cabinets, which are used to screen off electromagnetic fields. The device includes an elongate element the length of which agrees with the length of an adjacent door edge, and which is pivotable about an axis. Adjacent this axis this elongate element is provided with a first elongate contact surface, which, when the elongated element is pivoted to the closed position presses against the gasket.

Irrespective of what method is applied, there is still a further problem in achieving an effective seal between the doors to a cabinet with a pair of doors side by side, which are left- and right-hand hung.

### DISCLOSURE OF INVENTION

The object of the present invention is to achieve a sealing device which can be used in an apparatus in the joint between door and door frame as well as in the joint between two doors.

The problems is solved by a pivotable elongate element which, on being turned to its one end position for a closed door achieves that a metal gasket is compressed in the mentioned joints without the door warping or without its suspension means being appreciably loaded.

The invention is characterized by the disclosures in the claims.

### BRIEF DESCRIPTION OF DRAWINGS

The invention will now be described in detail with reference to the accompanying drawings, on which Figure 1 illustrates an apparatus cabinet and figures 2—4 illustrate different door joints in a cabinet, seen in cross-section from above. More specifically, Figure 2 illustrates a joint between two doors, Figure 3 a joint between door and door frame at the door suspension means and Figure 4 a joint between the closure edge of a door frame in a cabinet with only one door. Figures 5 and 6 illustrate embodiments of a gasket intended to be located in these joints.

### BEST MODE FOR CARRYING OUT THE INVENTION

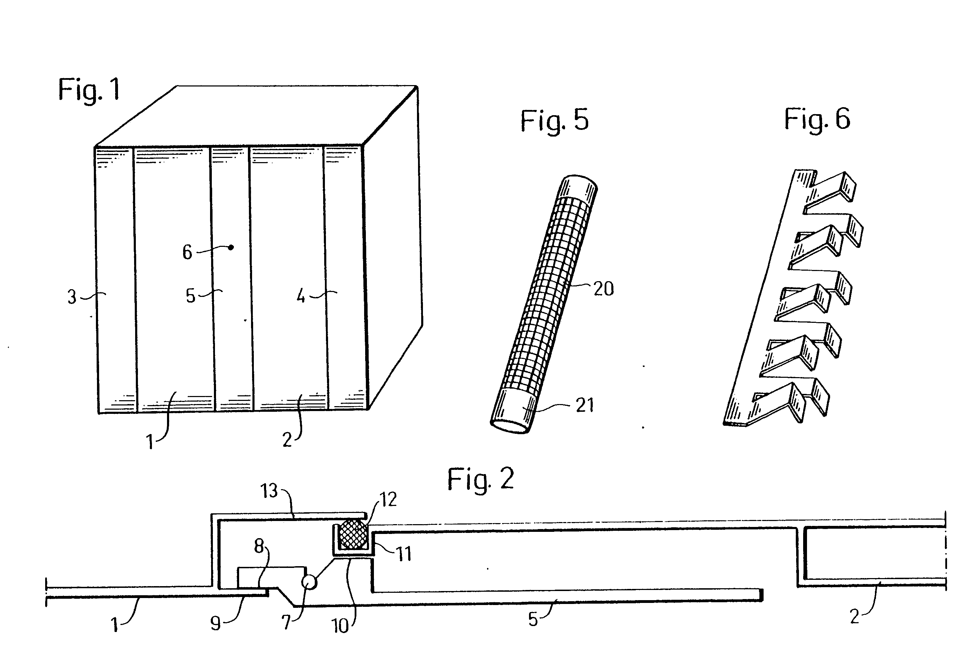

The apparatus cabinet according to Figure 1 is provided with two doors 1 and 2. Elongate elements 3, 4 and 5 are attached to the doors and extend parallel to the pivoting axes of the doors. Elements 3 and 4 are rigidly attached to the doors by fastening means, e.g. screwed joints, while the element 5 is pivotable in relation to them. A restraining means 6 may be used to keep the element 5 in an end position.

Figure 2 illustrates the elongate element 5 in cross-section, and how it achieves an effective seal between the doors 1 and 2. The element is hung at one side, and pivotable about pins 7. These pins are fixed in the upper and in the lower edge portions of door 2, adjacent its vertical edge, and may be rather short. In the vicinity of its pivoting axis the element has an inwardly directed elongate contact surface 10. When the element is turned to the illustrated end position, the surface 10 is intended to engage against the outside of a through-like projection 11 thrusting out from the door 2 and containing a metallic and compressible gasket 12. When the doors are closed this gasket engages against an abutment at the vertical edge portion of the door 1, this portion having a U-shaped cross-section, so that when the element is turned to its end position pressure is exerted against the projection 11 and thereby on the gasket 12. An elongate contact surface 8 on the element, facing away from the surface 10, is intended to engage against a second abutment 9 at the edge portion of the door.

A uniformly distributed pressure is provided along the entire gasket with the described device, and thereby effective sealing of the joint between both doors. This is because the gasket is compressed with relatively large pressure, due to the leverage effect of the element, which takes place without the pins on which the element is hung being loaded appreciably and without the doors warping.

The doors are retained in a closed position by the element being provided with the previously mentioned restraining means 6, not illustrated in Figure 2, which may be an ordinary sliding bolt, with which the element can be restrained in the illustrated end position and by the horizontal parts of the door frame being provided with unillustrated abutments pressing against the surface 8.

When the doors are to be opened, the element 5 must be first turned outwards, after which the door 2 can be opened, and then the door 1.

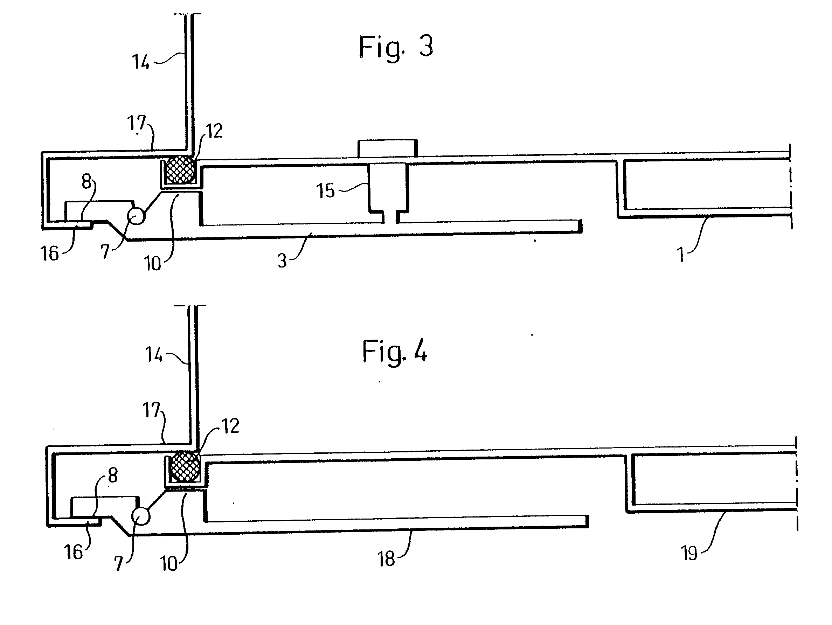

Figure 3 illustrates how the sealing device is used in a joint between a door and a door frame. The door corresponds to door 1, with the elongate element 3 attached to it according to Figure 1. The element, which functions as hinge for the door is pivotably mounted on the door frame, and is rigidly attached to the door by fastening means 15, e.g. a screwed joint. The element otherwise corresponds to the one previously described, except that it lacks restraining means. For a closed door, the gasket 12 is pressed against an abutment 17 in an edge portion of the door frame with a U-shaped cross-section, and the surface 8 against a second abutment 16 in the edge portion.

Effective sealing of a closed door is also achieved by this joint, due to the relatively large pressure, uniformly distributed along the gasket, with which the gasket is compressed. This takes place without the pins on which the door is hung being appreciably loaded and without the door warping.

Figure 4 illustrates how the seal can be achieved for the joint between the closure edge of a door 19 and the door frame in a cabinet with only one door. An elongate element 18 of the same embodiment as the element 5 is pivotably suspended in the door adjacent the door frame which, as previously is denoted by 14. The seal is achieved as with the joint according to Figure 3, but with the difference that the element 18 is not rigidly attached to the door. As was the case with the elongate element 5 according to Figure 2 the abutment 18 is also provided with an unillustrated restraining means, with which the element can be kept in the illustrated end position with the door closed.

The horizontal edges of the doors or the door of a cabinet are in general much shorter than the vertical edges, whereby the gaskets along the horizontal edges can be compressed without the doors warping.

Different embodiments of the metallic gasket 12 are illustrated in figures 5 and 6. According to Figure 5 it consists of woven metallic net 20 around an elongate elastic core 21 having a round cross-section.

According to Figure 6, the gasket consists of a comb-like plate, the teeth of which are bent at ends and have different slope so that the gasket can fill an elongate space.

Depending on what sealing capacity is desired different metals can be selected in which to manufacture the gasket.

## Claims

1. Sealing device for compressing metallic gaskets along edges of doors of metal cabinets, which are used to screen off electromagnetic fields, the device including an elongate element (3, 5, 18), the length of which agrees with the length of an adjacent door edge, and which is pivotable about an axis, the elongate element being provided with a first elongate contact surface (10) which, when the elongate element is pivoted to the closed position, presses against the gasket (12), characterized in that the said axis (7) is parallel to the pivoting axis of the door, in that said first elongate contact surface (10) presses against a door projection (11) containing the gasket (12) with a leverage effect about said axis (7) whereby a second elongate contact surface (8) disposed on the elongate element engages against an abutment (9, 16), so as to prevent the door from warping due to the pressure exercised on the gasket.

2. Device as claimed in claim 1, characterized in that the element (5) is suspended at the closure edge of the door (2), and that the abutment (9) comprises an elongate projection thrusting out from the closure edge of an adjacent door (1).

3. Device as claimed in claim 2, characterized in that the element (5) is provided with a restraining means (6) with which the element can be restrained in said end position.

4. Device as claimed in claim 1, characterized in that the element (3) is rigidly attached to the door (1) and constitutes a hinge for suspending the door on a door frame (14) of the cabinet.

5. Device as claimed in any one of the preceding claims, characterized in that the gasket (12) comprises an elastic core (21) surrounded by a metallic net (20).

6. Device as claimed in any one of the preceding claims, characterized in that the gasket (12) comprises a comb-like means of metal, its teeth being bent at the ends and forming at least two groups with different slope.

## Patentansprüche

1. Dichtungseinrichtung zum Anpressen von Metalldichtungen längs Türkanten von Metallschränken, die zum Abschirmen elektrischer Felder dienen, mit einem länglichen Bauelement (3, 5, 18), dessen Länge mit der Länge einer benachbarten Türkante übereinstimmt und das um eine Achse drehbar ist, wobei das längliche Bauelement mit einer ersten länglichen Kontaktfläche (10) versehen ist, die nach dessen Drehung in die Schließstellung gegen die Dichtung (12) drückt, dadurch gekennzeichnet, daß die Achse (7) parallel zur Drehachse der Türe angeordnet ist und daß die erste längliche Kontaktfläche (10) gegen einen Türvorsprung (11) drückt, in den die Dichtung (12) mit einer Hebelwirkung um die Achse (7) eingesetzt ist, wobei eine zweite, am länglichen Bauelement angeordnete längliche Kontaktfläche (8) gegen ein Widerlager (9, 16) drückt, so daß die Tür vor Verbiegen infolge des auf die Dichtung ausgeübten Druckes bewahrt wird.

2. Einrichtung nach Anspruch 1, dadurch gekennzeichnet, daß das Bauelement (5) an der Schließkante der Tür (2) aufgehängt ist und daß das Widerlager (9) einen länglichen Vorsprung besitzt, der von der Schließkante einer Nachbartüre absteht.

3. Einrichtung nach Anspruch 2, dadurch gekennzeichnet, daß das Bauelement (5) mit einem Haltemittel (6) versehen ist, mit dem die Tür in der Endposition gehalten werden kann.

4. Einrichtung nach Anspruch 1, dadurch gekennzeichnet, daß das Bauelement (3) an der Tür (1) fest angeordnet ist und zum Anhängen der Tür an einem Türrahmen (14) des Schrankes ein Scharnier bildet.

5. Einrichtung nach einem der vorangehenden Ansprüche, dadurch gekennzeichnet, daß die Dichtung (12) einen elastischen Kern (21) besitzt, der von einem Metallnetz (20) umgeben ist.

6. Einrichtung nach einem der vorangehenden Ansprüche, dadurch gekennzeichnet, daß die Dichtung (12) ein kammähnliches Mittel aus Metall umfaßt, dessen Zähne an den Enden umgebogen sind und mindestens zwei Gruppen mit unterschiedlicher Abschrägung bilden.

**Revendications**

1. Dispositif de fermeture étanche destiné à comprimer des garnitures métalliques le long de bords de portes d'armoires métalliques, qui sont utilisées pour faire écran à des champs électromagnétiques, le dispositif comprenant un élément allongé (3, 5, 18) dont la longueur correspond à la longueur d'un bord de porte adjacent et qui peut pivoter autour d'un axe, l'élément allongé présentant une première surface allongée (10) de contact qui, lorsque l'on fait pivoter l'élément allongé vers la position fermée, exerce une presion contre la garniture (12), caractérisé en ce que ledit axe (7) est parallèle à l'axe de pivotement de la porte, en ce que ladite première surface allongée (10) de contact exerce une pression contre une saillie (11) de la porte contenant la garniture (12), avec un effet de levier autour dudit axe (7) afin qu'une seconde surface allongée (8) de contact, située sur l'élément allongé, porte contre une butée (9, 16) pour empêcher ainsi le gauchissement de la porte sous l'effet de la pression exercée sur la garniture.

2. Dispositif selon la revendication 1, caractérisé en ce que l'élément (5) est suspendu au bord de fermeture de la porte (2) et en ce que la butée (9) comprend une saillie allongée ressortant du bord de fermeture d'une porte adjacente (1).

3. Dispositif selon la revendication 2, caractérisé en ce que l'élément (5) est muni de moyens (6) de retenue avec lesquels l'élément peut être retenu dans ladite position extrême.

4. Dispositif selon la revendication 1, caractérisé en ce que l'élément (3) est relié rigidement à la porte (1) et constitue une charnière pour suspendre la porte sur un bâti (14) de porte de l'armoire.

5. Dispositif selon l'une quelconque des revendications précédentes, caractérisé en ce que la garniture (12) comprend un noyau élastique (21) entouré d'un filet métallique (20).

6. Dispositif selon l'une quelconque des revendications précédentes, caractérisé en ce que la garniture (12) comprend un moyen en métal analogue à un peigne, métal, ses dents étant pliées aux extrémités et formant au moins deux groupes ayant des pentes différentes.

Fig. 6

Fig. 5

Fig. 1

Fig. 2

Fig. 3

Fig. 4